Europäisches Patentamt

(19) European Patent Office

Office européen des brevets

(11) Publication number : **0 589 721 A1**

(12) **EUROPEAN PATENT APPLICATION**

(21) Application number : 93307596.2

(22) Date of filing : 24.09.93

(51) Int. Cl.⁵ : **H04N 5/262, H04N 9/74**

(30) Priority : **25.09.92 KR 9217558**

(43) Date of publication of application :
**30.03.94 Bulletin 94/13**

(84) Designated Contracting States :
**DE GB NL**

(71) Applicant : **SAMSUNG ELECTRONICS CO.
LTD.**
**416 Maetan 3-dong, Kwonsun-ku
Suwon, Kyungki-do (KR)**

(72) Inventor : **Park, Wung-wook
114, Hanseo Apt., 407, Ganseok 1-dong
Namdong-gu, Icheon-city (KR)**
Inventor : **Paik, Joon-ki
7-605, Jamwonhanshim Apt., 56-3,
Jamwon-dong
Seocho-gu, Seoul (KR)**

(74) Representative : **Crawford, Fiona Merle et al
Elkington and Fife Prospect House 8
Pembroke Road
Sevenoaks, Kent TN13 1XR (GB)**

(54) **Digital zooming circuit with compensation of the edge degradation.**

(57)    A digital zooming system comprises field memories (6) for saving a digital video signal forming a predetermined colour array ; a sum/difference signal separator (5) for receiving the signal from the recording medium and then obtaining a sum value and difference value with respect to two neighbouring pixels among the pixels of the predetermined colour array ; a correlation calculating circuit comprising a sum-value interpolation calculator (7 and 8) for performing horizontal and vertical interpolations with respect to the sum-value according to a zooming ratio and a difference-value interpolation calculator (9 and 10) for calculating the horizontal and vertical interpolations and a digital low pass filter to compensate for edge degradation ; a sum/difference signal mixer (11) for receiving the interpolated sum value and difference value and producing the original digital video signal ; a digital-to-analog converter (12) for converting the digital video signal from the mixer into analog form ; an address generator (13) for generating an address signal for reading or writing the data recorded on the recording medium ; a coefficient generator (14) for inputting coefficients conforming to the zooming ratio to the sum-value and difference-value interpolation calculators ; and a control-signal generator (15) for generating a control signal for controlling each of the aforementioned elements. Hence, the system can be applied for a variety of magnifying factors and a high quality digital picture zoom can be accomplished.

FIG. 1

EP 0 589 721 A1

The present invention relates to a digital zooming system, and more particularly to a digital zooming system adopting a digital zooming method using a video signal from a charge-coupled device.

Hereinafter, conventional digital zooming systems will be explained.

In U.S. Patent No. 4,528,585, a television receiver having a picture magnifying apparatus employs a fixed magnification factor. Also, a variable magnification factor is realized in a digital still picture storage system with size change facility as disclosed in U.S. Patent No. 4,302,776, but in this instance, real-time processing is impossible. Further, a television picture zoom system disclosed in U.S. Patent No. 4,774,581 achieves both variable magnification and real-time processing, but its application field is restricted to the composite video signal processing of a television.

An object of the present invention is to provide a digital zooming system which is applicable to various magnification factors.

Another object of the present invention is to provide a digital zooming system which can perform real-time processing.

Another object of the present invention is to provide a digital zooming system which can be applied to a wide variety of fields.

A digital zooming system according to the present invention, comprises a recording medium for saving a digital video signal having a predetermined colour array; sum/difference signal separating means for receiving the signal from the recording medium and then obtaining a sum value and difference value with respect to two neighbouring pixels among the pixels of the predetermined colour array, the sum value obtained by summing the values of the two neighbouring pixels with a difference value representing the difference thereof; correlation calculating means comprising sum-value interpolation calculating means for performing horizontal and vertical interpolations with respect to the summed value of the two neighbouring pixels according to the zooming ratio and difference-value interpolation calculating means for calculating the horizontal and vertical interpolations with respect to the difference value between the two neighbouring pixels according to the zooming ratio; sum/difference signal mixing means for receiving the interpolated sum and difference values from the sum-value and difference-value interpolation calculating means and producing the original digital video signal; digital-to-analog converting means for converting the digital video signal from the mixing means into analog form; address generating means for generating an address signal for reading or writing the data recorded on the recording means; coefficient generating means for inputting coefficients corresponding to the zooming ratio to the interpolation calculating means; and control-signal generating means for generating a control signal for controlling each of the above means.

Embodiments of the present invention will now be described, by way of example, with reference to the accompanying drawings, in which:

Fig. 1 is a block diagram showing a digital zooming system according to an embodiment of the present invention;

Fig. 2 is a block diagram illustrating an embodiment of the sum/difference signal separating means shown in Fig. 1;

Fig. 3 is a block diagram illustrating an embodiment of the sum-value horizontal interpolation means shown in Fig.1;

Fig. 4 is a block diagram illustrating an embodiment of the sum-value vertical interpolation means shown in Fig.1;

Fig. 5 is a block diagram illustrating an embodiment of the difference-value horizontal interpolation means shown in Fig.1;

Fig. 6 is a block diagram illustrating an embodiment of the difference-value vertical interpolation and the filter shown in Fig.1;

Fig. 7 is a block diagram illustrating an embodiment of the sum/difference signal mixing means as shown in Fig.1;

Fig. 8 is a block diagram illustrating an embodiment of the address generating means shown in Fig.1;

Figs. 9A and 9B are block diagrams illustrating an embodiment of the coefficient generating means as shown in Fig. 1;

Fig.10 is a timing diagram for illustrating the operation of the sum/difference signal separating means; and

Fig.11 is a timing diagram for illustrating the operation of the difference-value vertical interpolation means.

Prior to describing the digital zooming system according to the present invention with the attached drawings, the algorithm thereof is explained hereinafter.

In general, a single-plate charge-coupled device produces a video signal having different complementary colour components due to a complementary colour filter, as follows:

| S1 | S2 | S3 | S4 | S5 | S6 | S7 | |
|----|----|----|----|----|----|----|----|
| Cy | Ye | Cy | Ye | Cy | Ye | Cy | ⋯ |
| G | Mg | G | Mg | G | Mg | G | ⋯ |
| Cy | Ye | Cy | Ye | Cy | Ye | Cy | ⋯ |
| Mg | G | Mg | G | Mg | G | Mg | ⋯ |
| Cy | Ye | Cy | Ye | Cy | Ye | Cy | ⋯ |
| ⋮ | ⋮ | ⋮ | ⋮ | ⋮ | ⋮ | ⋮ | |

In accordance with the array, the colour signal for the even field is output in a sequence of S1 of the summation of Cy (cyan) and G (green), S2 of the summation of Ye (yellow) and Mg (magenta), etc., and the colour signal for the odd field is output in a sequence of S1 of summation of Cy and Mg, S2 of summation of Ye and G, etc. The sum value Y and difference value D of the signals S1 and S2 are defined as:

$$Y1 = S1 + S2 = Cy + G + Ye + Mg \qquad ...(1)$$

$$D = S2 - S1 = Ye + Mg - Cy - G \qquad ...(2)$$

$$D = S2 - S1 = Ye + G - Mg - Cy \qquad ...(3)$$

At this time, Equations 2 and 3 show the even and odd horizontal lines, respectively. The sum value and difference value are interpolated in the vertical and horizontal directions according to the zooming ratio.

The vertical and horizontal interpolations for the sum value adopt a bilinear interpolation method, the horizontal interpolation for the difference value is performed by the bilinear interpolation method, and the vertical interpolation therefor adopts a nearest-neighbour interpolation (NNI) method. For sum-value interpolation, a sum value of a pixel is in correlation with neighbouring pixel data in the horizontal and vertical directions. Accordingly, sum-value interpolation uses the bilinear intepolation method. For difference value interpolation, the difference value is not in correlation with the neighbouring column pixel data, but instead can be interpolated with the pixel data of the next. Accordingly, difference-value vertical interpolation uses the NNI method.

The interpolation method wherein the value of a point X between two pixels A and B is calculated to interpolate its position, will be explained.

The distance between pixel A and the point X is denoted as $\alpha$, the distance between pixels A and B is set to one, and the distance between pixel B and point X is denoted as $\beta$. Accordingly, $\beta$ equals 1-$\alpha$, and when using $\alpha$ and $\beta$ to express these distances, the interpolation value of X becomes $\beta$A+$\alpha$B.

Here, the horizontal interpolation of the difference value produces a signal degradation near the edge portion, so that a digital low-pass filter is used to compensate for the degradation. The digital low-pass filter used in the present invention has the following characteristics.

$$H(z) = \frac{0.75 + 0.5z^{-1} + 0.75z^{-2}}{2} \qquad (4)$$

The interpolation results with respect to the sum value and difference value are denoted as Y" and D", respectively. The original signals S1 and S2 are obtained by the use of the interpolation results.

$$\frac{Y''-D}{2} = \frac{(Ye+Mg+Cy+G)-(Ye+Mg-Cy-G)}{2}$$
$$= Cy + G$$
$$= S1 \qquad \qquad \ldots(5)$$

$$\frac{Y''+D}{2} = \frac{(Ye+Mg+Cy+G)+(Ye+G-Cy-G)}{2}$$
$$= Ye + Mg$$
$$= S2 \qquad \qquad \ldots(6)$$

$$\frac{Y''-D}{2} = \frac{(Ye+Mg+Cy+G)-(Ye+G+Mg-Cy)}{2}$$
$$= Cy + Mg$$
$$= S1 \qquad \qquad \ldots(7)$$

$$\frac{Y''+D}{2} = \frac{(Ye+Mg+Cy+G)+(Ye+G-Cy-Mg)}{2}$$
$$= Ye + G$$
$$= S2 \qquad \qquad \ldots(8)$$

By the use of the above equations 5, 6, 7 and 8, the interpolated results Y" and D" produce the magnified signals S1 and S2.

The digital zooming system according to the present invention for performing the aforementioned algorithm will be hereinafter explained.

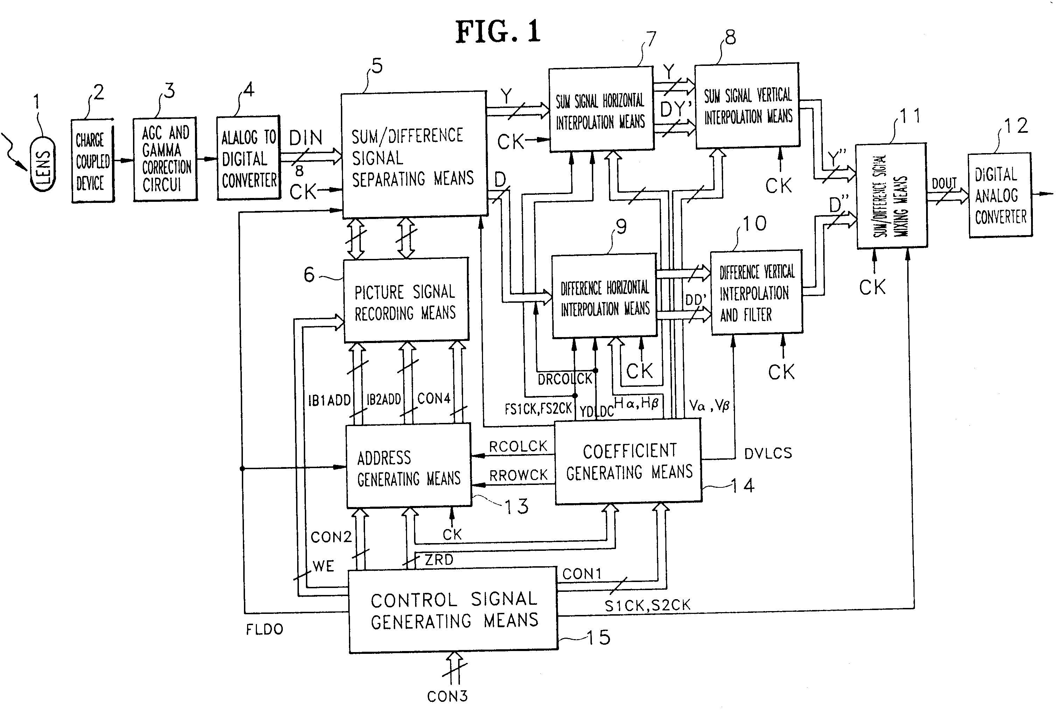

Fig. 1 shows a block diagram of the digital zooming system according to an embodiment of the present invention.

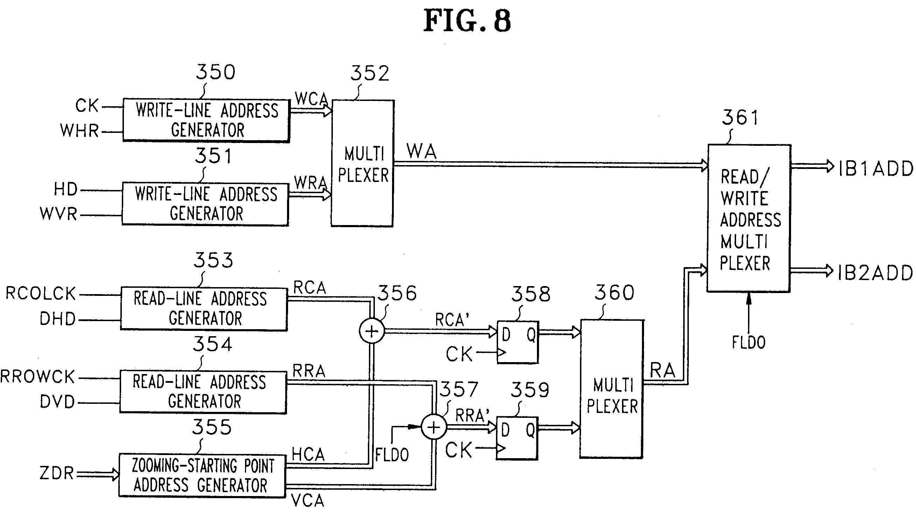

Relating to Fig.1, the incident light via a lens 1 is converted into an electrical signal by a charge-coupled device 2. The signal is processed through an automatic gain controller (AGC) and gamma correction circuit 3. The analog signal output from AGC and gamma correction circuit 3 is converted into digital form by analog-to-digital converting circuit 4. The converted digital video signal is recorded on video signal recording means 6 via sum/difference signal separation means 5. From the recorded signal, sum signal Y and difference signal D are obtained by sum/difference signal separating means 5. The sum signal Y is horizontally interpolated by a sum-value horizontal interpolation circuit 7, so as to produce interpolation result Y' and a one-horizontal-line-delayed interpolation result DY'. The interpolation results Y' and DY' are vertically interpolated by a sum-value vertical interpolation circuit 8 so as to produce the final sum-value interpolation result Y'. The difference signal D is horizontally interpolated by the difference-value interpolation signal 9, so as to produce an interpolation result D' and a one-horizontal-line-delayed interpolation result DD'. The interpolation results D' and D" are vertically interpolated and filtered by a difference-value vertical interpolation circuit and filter 10 so as to produce the final interpolation result D". The finally interpolated results Y" and D" are processed by sum/difference signal mixing means 11 so as to produce a magnified digital video signal which is then converted into analog form by a digital-to-analog converter 12. Address generating means 13 produces address IB1ADD and IB2ADD and control signal CON4 for recording and reading-out the data of video signal recording means 6. According to the zooming ratio, coefficient generating means 14 produces signals RCOLCK and RROWCK for controlling the address generation of address generating means 13, and coefficients Hα and Hβ and clock signals DRCOLCK, FS1CK and FS2CK for sum-value horizontal interpolation means 7 and difference-value horizontal interpolation means 9. Coefficient generating means 14 also provides sum-value vertical interpolation means 8 with coefficients Vα and Vβ according to the zooming ratio, and provides difference-value vertical interpolation means and filter 10 with a control signal DVLCS. The control-signal generating means 15 receives control signal CON3 and thus produces control signals for controlling each of the aforementioned means. That is, control-signal generating means 15 produces field output signal FLD0 for controlling sum/difference signal separating means 5 and address generating means 13, write-enable signals WE1 and WE2 for enabling the data recording of video signal recording means 6, a control signal CON2 for controlling the address generating means 13, and data ZRD conforming to the zooming ratio. Control-signal generating means 15 also provides the coefficient generating means 14 with the zoom-ratio data and the control signal CON1, and provides the sum/difference signal mixing means 11 with the control signals S1CK and S2CK. Signals DHD and DVD (FIG.8) are indicated by the first control signal CON1, signals WHR, WVR, DHD and DVD (FIG.8) are indicated by the second control signal CON2, and signals CK, HD, VD, FLD0 and ZRD (FIG.1) are indicated by the third control signal CON3.

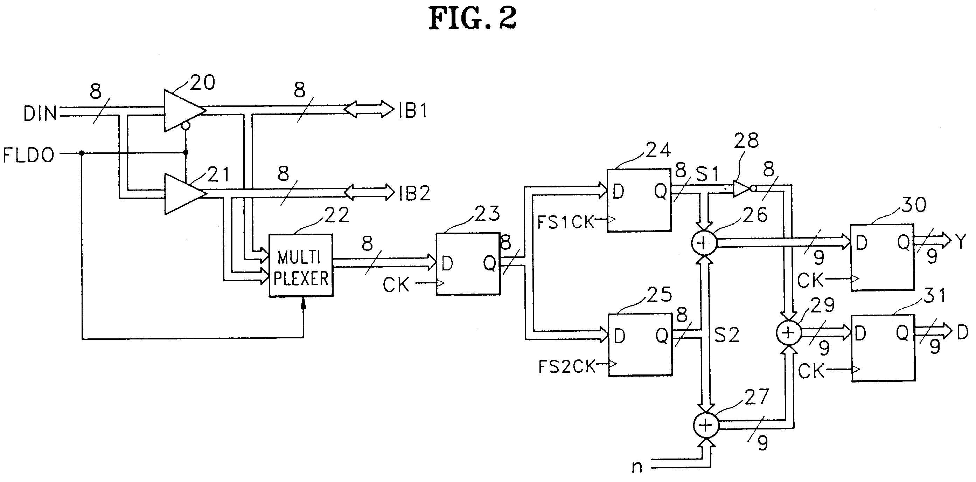

Fig.2 is a block diagram illustrating the sum/difference signal separating means of an embodiment according to the present invention.

In Fig.2, the sum/difference signal separating means comprises a buffer 20 for outputting the digital video signal DIN to the first video signal recording means (not shown) of video signal recording means 6 (Fig.1) by responding to the low level of the field output signal FLD0, another buffer 21 for outputting digital video signal DIN to the second video signal recording means (not shown) of video signal recording means 6 (Fig. 1) by responding to the high level of field output signal FLD0, a multiplexer 22 for alternately producing the output signal from video signal recording means 6 while responding to field output signal FLD0, D flip-flop 23 for synchronizing the output signal of multiplexer 22 by responding to the system clock CK, another D flip-flop 24 for alternately receiving signal S1 among the signals from D flip-flop 23 while responding to the signal FS1CK, another flip-flop 25 for alternately receiving signal S2 among the signals from D flip-flop 23, an adder 26 for summing the output signals of D flip-flop 24 and D flip-flop 25, another adder 27 for adding a predetermined value n to the output signal of D flip-flop 25, inverting means 28 for inverting the output signal of D flip-flop 24, another adder 29 for summing the output signals of inverting means 28 and adder 28, D flip-flop 30 for synchronizing the output signal of adder 26 by responding to clock signal CK, and D flip-flop 31 for synchronizing the output signal of adder 29 by responding to clock signal CK. Sum signal Y and difference signal D are output from D flip-flops 30 and 31, respectively.

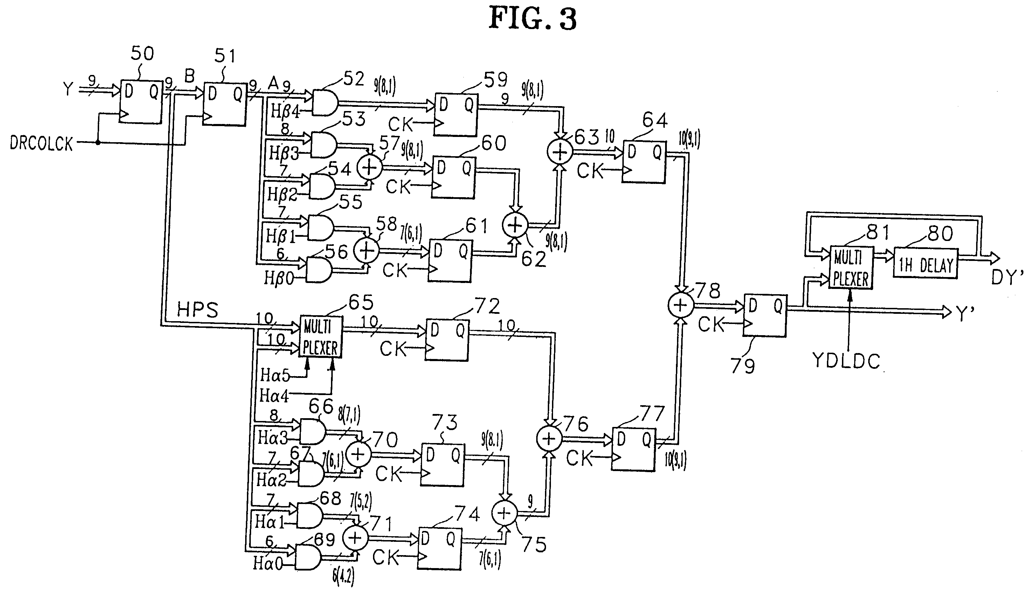

Fig. 3 shows a sum-value horizontal interpolation circuit according to the embodiment shown in Fig.1.

In Fig.3, the sum-value horizontal interpolation circuit comprises series-connected D flip-flops 50 and 51 for synchronizing the sum signal Y while responding to the delayed read line address clock DRCOLCK; AND gate means 52-56 for logically multiplying the output signal of D flip-flop 51 by data Hβ4-Hβ0 which corresponds to the zooming ratio; an adder 57 for receiving and adding the output signals of AND gate means 53 and 54; an adder 58 for receiving and summing the output signals of AND gate means 55 and 56; a D flip-flop 59 for synchronizing the output signal of AND gate means 52 by responding to the clock signal CK; a D flip-flop 60 for synchronizing the output signal of adder 57 by responding to clock signal CK; a D flip-flop 61 for synchronizing the output signal of adder 58 by responding to clock signal CK; an adder 62 for summing the output signals of D flip-flops 60 and 61; an adder 63 for receiving and summing the output signals of D flip-flop 59 and adder 62; D flip-flop 64 for synchronizing the output signal of adder 63 by responding to clock signal CK; a multiplexer 65 for multiplexing the signal from D flip-flop 50 by responding to coefficients Hα5 and Hα4; AND gate means 66, 67, 68 and 69 for receiving the output signal from D flip-flop 50 and coefficients Hα3, Hα2, Hα1 and Hα0 and logically multiplying the output signal by each coefficient; an adder 70 for summing the output signals of AND gate means 66 and 67; an adder 71 for summing the output signals of AND gate means 68 and 69; a D flip-flop 72 for synchronizing the output signal of multiplexer 65 by responding to clock signal CK; a D flip-flop 73 for synchronizing the output signal of adder 70; a D flip-flop 74 for synchronizing the output signal of adder 71; an adder 75 for summing the output signals of D flip-flops 73 and 74; an adder 76 for summing the output signals of D flip-flop 72 and adder 75; D flip-flop 77 for synchronizing the output signal of adder 76 by responding to clock signal CK; an adder 78 for summing the output signals of D flip-flops 64 and 77; D flip-flop 79 for interpolating the output signal of adder 78 in the horizontal direction, to thereby produce a signal Y'; delay means 80 for delaying the output signal of D flip-flop 79 for one-horizontal-scanning period and generating a delayed interpolation signal DY'; and a multiplexer 81 for selectively producing the output signal of delay means 80 or the output signal of D flip-flop 79 by responding to control signal YDLDC.

As in the above structure, D flip-flops 51, 59, 60, 61 and 64, AND gate means 52, 53, 54, 55 and 56, and adders 57, 58, 62 and 63 constitute means for multiplying the value of the first among two pixels, by the distance between any point and the first pixel. D flip-flops 50, 72, 73, 74 and 77, multiplexer 65, adders 70, 71, 75 and 76 and AND gate means 66, 67, 68 and 69 constitute means for multiplying the value of the second pixel by the distance between any point and the second pixel. Adder 78 and D flip-flop 79 are means for summing the above-calculated two products. Multiplexer 81 and delay 80 for delaying a horizontal line are for maintaining the required line for the sum-value vertical interpolation, and for maintaining a one line delay as the zooming ratio increases over several lines.

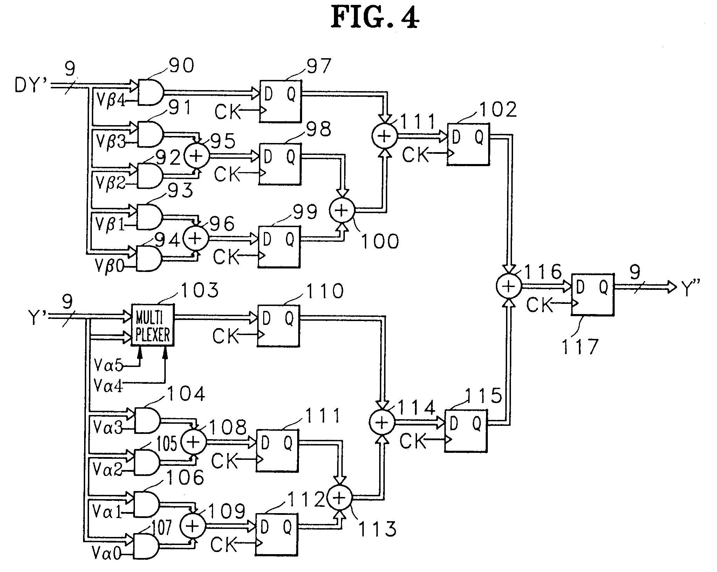

Fig. 4 shows an embodiment of the sum-value vertical interpolation means shown in Fig.1.

In Fig. 4, AND gate means 90, 91, 92, 93 and 94, adders 95, 96, 100 and 111, and D flip-flops 97, 98, 99 and 102 are means for receiving and multiplying the output signal DY' of the sum-value horizontal interpolation means 7 (Fig.1) by coefficients $V\beta 4$, $V\beta 3$, $V\beta 2$, $V\beta 1$ and $V\beta 0$ from coefficient generating means 14 (Fig.1) which are distances to any point X corresponding to the zooming ratio. Multiplexer 103, AND gate means 104, 105, 106 and 107, adders 108, 109, 113 and 114, and D flip-flops 110, 111, 112 and 115 are means for receiving and multiplying the output signal Y' of the sum-value horizontal interpolation means 7 by coefficients $V\alpha 5$, $V\alpha 4$, $V\alpha 3$, $V\alpha 2$, $V\alpha 1$ and $V\alpha 0$ from coefficients generating means 14 which are also distances to any point X corresponding to the zooming ratio. Adder 116 and D flip-flop 117 are means for summing the above multiplied two numbers so as to produce the finally obtained sum-value interpolation result Y".

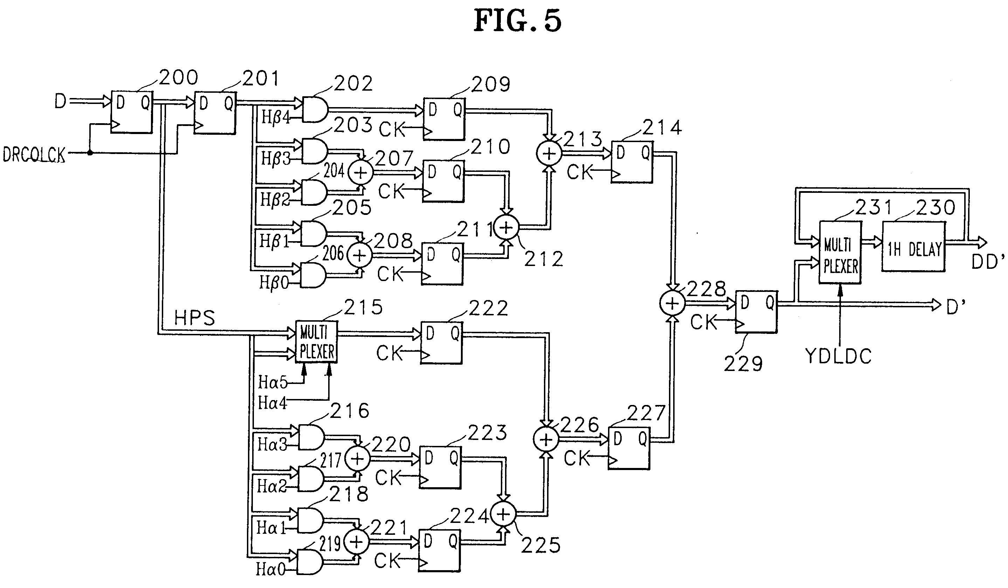

Fig. 5 is a diagram showing an embodiment of the difference-value horizontal interpolation means as shown in Fig.1.

In Fig. 5, the difference-value horizontal interpolation means is constituted the same as that of the sum-value horizontal interpolation means 7 (Fig.3) save for receiving difference signal D instead of the sum signal Y. Here, the reference numerals are denoted differently.

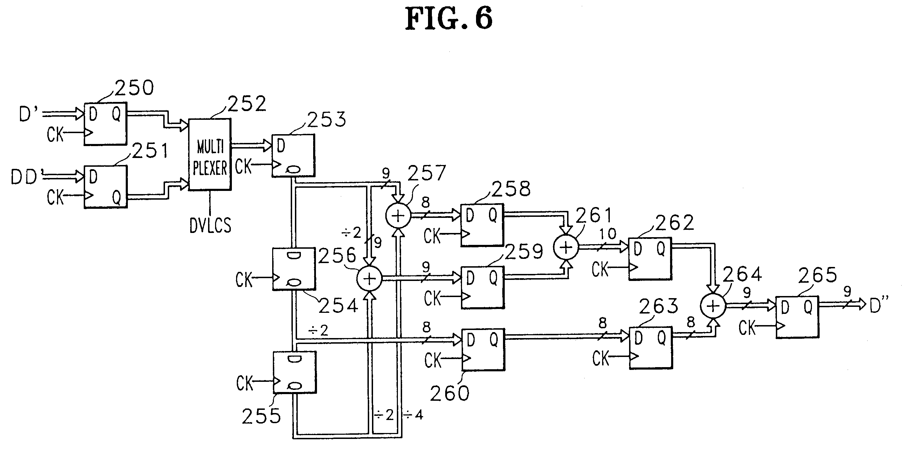

Fig. 6 is a diagram showing the structure of the sum-value vertical interpolation means and filter of Fig.1.

In Fig. 6, the sum-value vertical interpolation means and filter comprises a D flip-flop 250 for synchronizing the output signal D' of difference-value horizontal interpolation means 9 (Fig.1) by responding to the clock signal CK; a D flip-flop 251 for synchronizing one-horizontal-line-delayed output signal DD' of difference-value horizontal interpolation means 9 (Fig.1) by responding to clock signal CK; and a multiplexer 252 for alternately producing the output signals of D flip-flops 250 and 251 by responding to control signal DVLCS, thereby constituting means for performing the NNI operation. Also, the sum-value vertical interpolation means and filter comprises a D flip-flop 253 for synchronizing the output signal of multiplexer 252 by responding to clock signal CK; a D flip-flop 254 for synchronizing the output signal of D flip-flop 253; a D flip-flop 255 for synchronizing the output signal of D flip-flop 254; an adder 256 for adding the divided-by-two output signal of D flip-flop 253 to the divided-by-two output signal of D flip-flop 255; an adder 257 for adding the divided-by-four output signal of D flip-flop 253 to the divided-by-four output signal of D flip-flop 255; a D flip-flop 258 for synchronizing the output signal of adder 257 by responding to clock signal CK; a D flip-flop 259 for synchronizing the output signal of adder 256; a D flip-flop 260 for recording and producing the divided-by-two output signal of D flip-flop 254 by responding to clock signal CK; an adder 261 for summing the output signals of D flip-flops 258 and 259; D flip-flop 262 for synchronizing the output signal of adder 261 by responding to clock signal CK; D flip-flop 263 for synchronizing the output signal of adder 261 by responding to clock signal CK; an adder 264 for summing the output signals of D flip-flops 262 and 263; and a D flip-flop 265 for recording the output signal of adder 264 and producing the finally obtained difference-value interpolation result D", thereby constituting digital filter means for removing the noise component which takes place in the difference-value horizontal interpolation.

Here, the digital filtering means has characteristics in accordance with the above Equation 4.

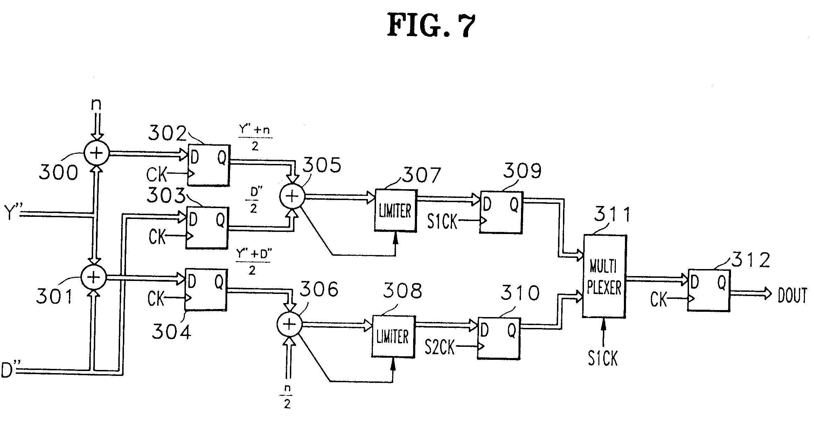

Fig. 7 shows a structure of a sum/difference signal mixing means shown in Fig. 1. In Fig. 7, the sum/difference signal mixing means comprises an adder 300 for adding the output signal Y" of the sum-value vertical interpolation means 8 (Fig.1) to a predetermined number n; an adder 301 for receiving and summing the output signals Y" and D" from the sum-value vertical interpolation means and the difference-value vertical interpolation means 8 and 10 (Fig.1); a D flip-flop 302 for recording and producing the output signal of adder 300 by responding to clock signal CK; a D flip-flop 303 for receiving and producing the output signal D" of the difference-value vertical interpolation means and filter 10 (Fig.1) by responding to the clock signal; a flip-flop 304 for recording and producing the output signal of adder 301 by responding to clock signal CK; an adder 305 for receiving and adding the divided-by-two output signal Y of D flip-flop 302 to the divided-by-two output signal D" of D flip-flop 303; an adder 306 for receiving and adding the divided-by-two output signal Y" + D" of D flip-flop 304 and the predetermined number divided by two; a limiter 307 for producing a limiting value when the output signal of adder 305 is larger than the limiting value; a limiter 308 for producing a limiting value when the output signal of adder 306 is larger than the limiting value; a D flip-flop 309 for recording and producing the output signal of limiter 307 by responding to clock signal S1CK; a D flip-flop 310 for recording and producing the output signal of limiter 308 by responding to clock signal S2CK; a multiplexer 311 for selectively outputting the output signals of D flip-flops 309 or 310 by responding to clock signal S1CK; and a D flip-flop 312 for recording and producing the output signal of multiplexer 311 by responding to clock signal CK.

Fig. 8 shows the structure of the address generating means shown in Fig.1 In Fig. 8, write-line address generator 350 is for responding to clock signal CK and thereby generating the write-line address, and is reset by the control signal WHR. Write-column address generator 351 is for responding to a signal HD and thereby generating write-column address. A multiplexer 352 selectively outputs the write-line address or write-column address. A read-line address generator 353 responds to a read-line address clock signal RCOLCK and thereby generates a read-line address. A read-column address generator 354 responds to read-column address clock signal RROWCK and thereby generates a read-column address. A zooming-start address generator 365 generates the address of the zooming starting point, which is a horizontal-compensation address HCA. An adder 356 adds the output of read-line address generator 353 to the output of the zooming-start address generator 355, so as to produce a signal RCA'. D flip-flop 358 records and produces signal RCA' by responding to clock signal CK. An adder 357 adds the output of read-line address generator 354 to the vertical-compensation address VCA generated by the zooming-start address generator 355 and thereby produces a signal RRA'. D flip-flop 359 records and produces signal RRA' by responding to clock signal CK. The output signal of D flip-flops 358 and 359 are input to a multiplexer 360 which produces a final read-address RA. A multiplexer 361 selectively outputs write-address WA or read-address RA by responding to the signal FLD0.

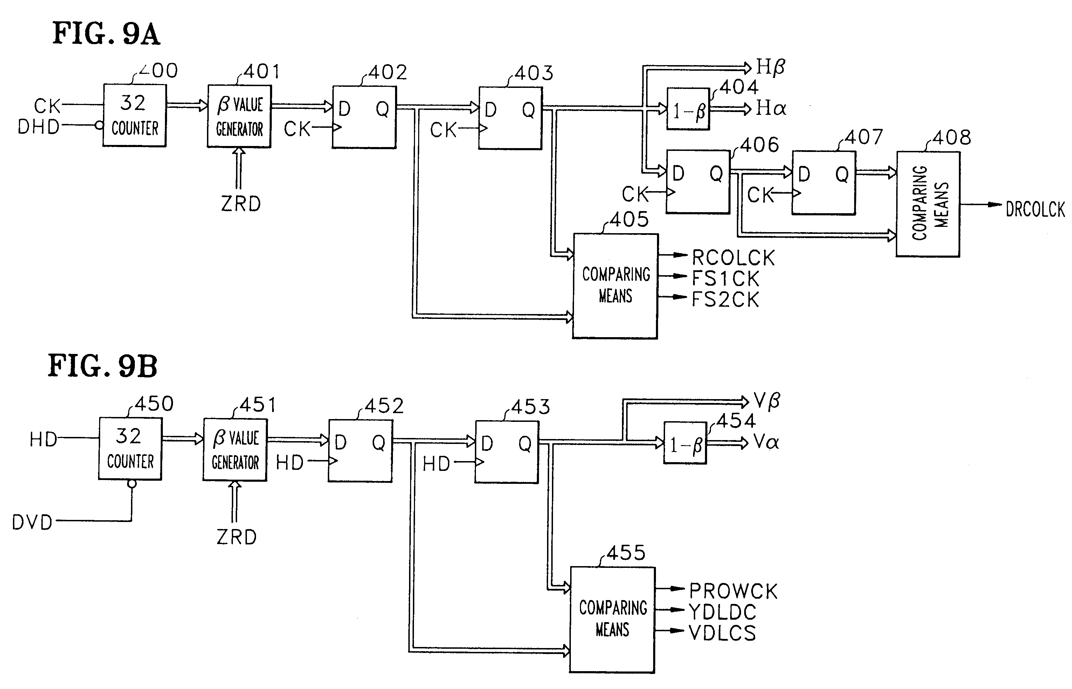

Figs. 9A and 9B show an embodiment of the coefficient generating means shown in Fig.1.

Fig. 9A shows a circuit for generating the coefficient received and used by the sum-value horizontal interpolation means 7 and the difference-value horizontal interpolation means 9. In Fig. 9A, the coefficient generating circuit comprises 32-counting means 400 which is enabled by the signal DHD and counting clock signal CK; $\beta$-value generating means 401 for receiving the output signal of counting means 400 and then generating $\beta$-value according to the zooming ratio data ZRD; D flip-flops 402 and 403 for recording and outputting the $\beta$-value by responding to clock signal CK; 1-$\beta$ value generating means 404 for receiving the $\beta$ value from D flip-flop 403 and generating the value of $\alpha(\alpha=1-\beta)$; D flip-flops 406 and 407 for recording and outputting the $\beta$-value by responding to clock signal CK; comparing means 408 for comparing the output signals of D flip-flops 406 and 407 and producing a delayed line-address clock signal DRCOLCK; and comparing means 405 for receiving and comparing the output signals of D flip-flops 402 and 403 and thus producing signals RCOLCK, FS1CK and FS2CK.

Fig. 9B shows a circuit for producing the coefficient input to the sum-value vertical interpolation means. In Fig. 9B, the circuit comprises 32-counting means 450 which is enabled by a signal DVD and counting signal HD; $\beta$-value generating means 451 for receiving the output signal of counting means 450 and producing the $\beta$-value according to the zooming ratio; D flip-flops 452 and 453 for recording and producing the $\beta$-value by responding to signal HD; $\alpha$-value generating means 454 for receiving the output signal, i.e., $\beta$-value, from D flip-flop 453 and then producing the $\alpha$ value; and comparing means 455 for comparing the output signals of D flip-flops 452 and 453 and then producing the signals RROWCK, YDLDC and DVLCS.

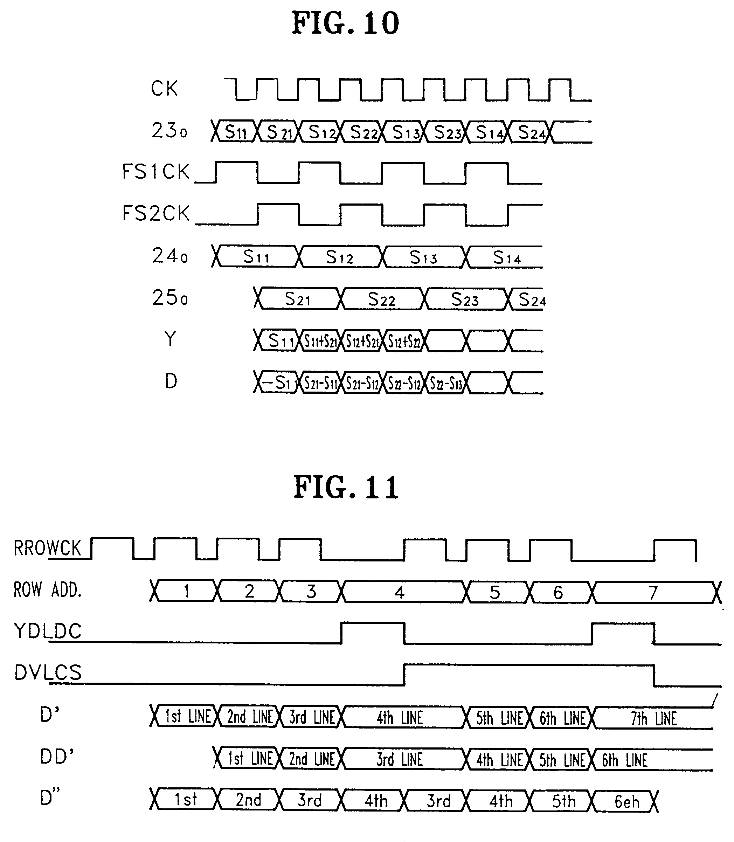

Fig. 10 is an operation timing diagram showing the operation of the sum/difference signal separating means of Fig.2. Although not illustrated in the drawings, the first picture signal recording means (Fig.1) comprises video signal recording means for recording the even-field images IB1 and the second video signal recording means for recording the odd-field images IB2.

Table 1 classifies how the picture signal recording means operates.

Table 1

| FLD | FLD0 | IB1WE | IB2WE |
|---|---|---|---|
| HIGH (ODD FIELD) | LOW | LOW | HIGH |
| LOW (EVEN FIELD) | HIGH | HIGH | LOW |

In Table 1, when field signal FLD falls to a logic "low," the field output signal FLD0 is high and picture signal recording means IB1 and IB2 are high and low, respectively. Also, when field signal FLD goes high, the field output signal FLD0 is low and picture signal recording means IB1 and IB2 are low and high, respectively. In Table 1, the low logic level denotes a write-mode and the high logic level denotes a read-mode. The picture signal recording means IB1 and IB2 cannot simultaneously operate in the same mode, but alternate their respective operations between the write-mode and read-mode. Accordingly, the data output from D flip-flop 23 is in the sequence $23_0$ of Fig. 10. Also, the outputs from D flip-flops 24 and 25 are in the sequences $24_0$ and $25_0$ of Fig. 10, by responding to control signals FS1CK and FS2CK, respectively. With reference to Fig.2, an add operation is performed through adders 26, 27 and 28 and inverting means 28, so as to produce sum signal Y and difference signal D. Here, a predetermined number n is added to avoid the occurrence of negative values when calculating difference signal D.

Fig.11 shows an operational timing diagram for illustrating the operation of the difference-value vertical interpolation means, where the zooming ratio data is eight. Output signals D' and D" of difference-value vertical interpolation means 9 (Fig.1) are selected according to signal DVLCS, thereby avoiding the colour degradation between lines caused by the NNI operation being performed to difference signal D. Referring to Fig. 11, when the signal DVLCS is low, output signal D' is selected, and when the signal DVLCS is high, output signal DD' is selected.

Using the values of Hαs and Hβs of Fig.3, the interpolated values of X (between points A and B) are tabulated in Table 2.

## Table 2

| Hα5 | Hα4 | Hα3 | Hα2 | Hα1 | Hα0 | Hβ4 | Hβ3 | Hβ2 | Hβ1 | Hβ0 | X |
|---|---|---|---|---|---|---|---|---|---|---|---|
| 1 | 0 | 0 | 0 | 0 | 0 | 0 | 0 | 0 | 0 | 0 | 32/32B |
| 0 | 1 | 1 | 1 | 1 | 1 | 0 | 0 | 0 | 0 | 1 | 1/32A+31/32B |
| 0 | 1 | 1 | 1 | 1 | 0 | 0 | 0 | 0 | 1 | 0 | 2/32A+29/32B |
| 0 | 1 | 1 | 1 | 0 | 1 | 0 | 0 | 0 | 1 | 1 | 3/32A+29/32B |
| ⋮ | | | | | | | | | | | ⋮ |
| 0 | 0 | 0 | 0 | 1 | 1 | 1 | 1 | 1 | 1 | 1 | 31/32A+1/32B |

Referring to Table 2, it should be noted that the pixel value of any point X between two pixels is determined according to the logic level of the coefficients generated by the coefficient generating means.

Table 3 shows the values for $\beta$ according to zooming ratios.

## Table 3

| ZRD | | | | | $\beta$ (/32) | | | | | | | | |
|---|---|---|---|---|---|---|---|---|---|---|---|---|---|
| 0 | 0 | 0 | 0 | 0 | 0 | 0 | 0 | 0 | 0 | 0 | ... | 0 | 0 |
| 0 | 0 | 0 | 0 | 1 | 0 | 1 | 2 | 3 | 4 | 5 | | 30 | 31 |
| 0 | 0 | 0 | 1 | 0 | 0 | 2 | 4 | 6 | 8 | 10 | | 28 | 30 |
| 0 | 0 | 0 | 1 | 1 | 0 | 3 | 6 | 9 | 12 | 15 | | 26 | 29 |
| ⋮ | | | | | | | | | | | | | ⋮ |
| 1 | 1 | 0 | 0 | 0 | 0 | 24 | 16 | 8 | 0 | 24 | ... | 8 | 0 |

As shown in Table 3, after the coefficient B is produced from vertical coefficient generating means 401, the value 1-$\beta$ is calculated so as to obtain the $\alpha$ value. Let us assume the address and data as follows:

Table 4

| Address | 1 | 2 | 3 | 4 | 5 | 6 |
|---|---|---|---|---|---|---|
| Data | A | B | C | D | E | F |
| Zoomed picture | a | b | c | d | e | f | g |

Table 5 shows the coefficients and address essential for acquiring a zoomed picture having a zooming ratio of eight.

Table 5

| Zoomed data | Necessary data for zooming | | $\alpha$ | $\beta$ | Address |
|---|---|---|---|---|---|
| a | | A | 32/32 | 0 | 1 |
| b | A | B | 24/32 | 8/32 | 2 |
| c | B | C | 16/32 | 16/32 | 3 |
| d | C | D | 8/32 | 24/32 | 4 |
| e | | D | 32/32 | 0 | 4 |
| f | D | E | 24/32 | 8/32 | 5 |
| g | E | F | 16/32 | 16/32 | 6 |

Referring to Table 5, according to the zooming ratio data, different address forms are obtained. In comparing the address with the $\beta$ value, it should be noted that, when $\beta$ starts to decrease, the address remains unchanged and retains its prior value. Therefore, the read-address is determined by observing the change of the $\beta$ value. The output signals from D flip-flops 402 and 403 as shown in Fig.9A are compared in comparing means 405, and if the output signal of D flip-flop 403 is greater than or equal to that of D flip-flop 402, read-line address clock signal RCOLCK is produced. Otherwise, signal RCOLCK is not produced.

Delayed line address clock signal DRCOLCK is in the same form as that of read-line address clock signal RCOLCK, but is slightly delayed. The delayed signal is necessary because signal RCOLCK is used for address generation for reading the video data from picture signal recording means 6, but the delayed line address clock signal DRCOLCK is used after the signals S1 and S2 have been used for producing the sum and difference signals.

Also, the digital zooming system according to embodiments of the present invention separately produces the signals WVR and DVD (Fig.8) so that operation in both NTSC and PAL modes is possible. Signal WVR enables the write-column address and is generated at the leading edge of horizontal delay HD as follows:

9HD: NTSC-Hi
10HD: NTSC-Normal
16HD: PAL-Normal/Hi

Signal DVD enables read-column address and is generated at the leading edge of horizontal signal HD as follows:

7HD: NTSC-Hi
8HD: NTSC-Normal
14HD: PAL-Normal/Hi

Signal WHR enables write-line address and is generated at the trailing edge of clock signal CK as follows:

17CK: NTSC-Normal
24CK: NTSC-Hi; PAL-Normal/Hi

Signal DHD enables read-line address and is generated at the trailing edge of clock signal CK as follows:

1CK: NTSC-Normal
8CK: NTSC-Hi; PAL-Normal/Hi

Accordingly, embodiments of the present invention provide a digital zooming system, having the following advantages: (1) it can be used for a variety of magnification factors; (2) the interpolation method of the present invention does not use multipliers as does the conventional interpolation method, and instead adopts adders, D flip-flops and AND gates, so that a more efficient hardware construction is achieved; (3) digital zooming is achieved with high picture quality; (4) it can be used for both NTSC and PAL systems; and (5) it can be applied to any system utilizing a digital zooming function.

While the present invention has been particularly shown and described with reference to particular embodiments thereof, it will be understood by those skilled in the art that various changes in form and details may be effected therein without departing from the scope of the invention.

## Claims

1. A digital zooming system comprising:

recording means (6) for recording a digital video signal representing a colour array converted into digital form and having a predetermined order;

sum/difference signal separating means (5) for receiving the signal from said recording means and obtaining a sum value and difference value of two neighbouring pixels among a plurality of pixels which establish a predetermined colour array;

interpolation calculating means comprising sum-value interpolation calculating means (7,8) for calculating the horizontal interpolation and the vertical interpolation with respect to said sum value according to the zooming factor, and difference-value interpolation calculating means (9,10) for calculating the horizontal interpolation and the vertical interpolation with respect to said difference value according to the zooming factor;

sum/difference signal mixing means (11) for receiving the sum-value and difference-value interpolation signals from said interpolation calculating means, and producing the original digital video signal;

digital-to-analog converting means (12) for converting the digital video signal from said mixing means into an analog form having the colour array in the predetermined order;

address generating means (13) for producing an address signal for reading-out or recording the data in said recording means;

coefficient generating means (14) for producing and sending coefficients corresponding to said zooming factor to said interpolation calculating means; and

control-signal generating means (15) for generating a control signal for controlling each of said means.

2. A digital zooming system as claimed in claim 1, wherein said sum/difference signal mixing means (11) comprises a first adder (26) for summing the first and second colour array data so as to produce a signal representing said sum value, and a second adder (27) for subtracting the first colour array data from the second colour array data so as to produce a signal representing said difference value, said first and second colour array data being arranged according to the predetermined order.

3. A digital zooming system as claimed in claim 2, wherein said second adder (27) adds a predetermined number to the result thereof, so as to avoid a negative value in the calculation result.

4. A digital zooming system as claimed in any preceding claim, wherein said sum-value interpolation calculating means comprises first interpolation calculating means (7) for calculating the horizontal interpolation with respect to said sum value and second interpolation calculating means (8) for receiving the output signal from said first interpolation calculating means and calculating the vertical interpolation thereof.

5. A digital zooming system as claimed in claim 4, wherein, assuming that the distance between said two neighbouring pixels consisting of a first pixel and a second pixel equals one and that the value of an arbitrary pixel is known, said first interpolation calculating means (7) performs said horizontal interpolation by adding a first value obtained by multiplying the value of said first pixel by the distance between said arbitrary pixel and said second pixel, to a second value obtained by multiplying the value of said second pixel by the distance between said arbitrary pixel and said first pixel.

6. A digital zooming system as claimed in claim 4 or 5, wherein said first interpolation calculating means (7) further comprises a delay circuit 80 for delaying the calculated value for one horizontal scanning period.

7. A digital zooming system as claimed in any of claims 4 to 6, wherein, assuming that the distance between said two neighbouring pixels consisting of a first pixel and a second pixel equals one and that the value of an arbitrary pixel is known, said second interpolation calculating means (8) performs said vertical interpolation by adding a first value obtained by multiplying the value of said first pixel by the distance between said arbitrary pixel and said second pixel, to a second value obtained by multiplying the value of said second pixel by the distance between said arbitrary pixel and said first pixel.

8. A digital zooming system as claimed in any preceding claim, wherein said difference-value interpolation calculating means further comprises:

first difference-value interpolation calculating means (9) for calculating the horizontal interpolation with respect to said difference signal;

second difference value interpolation calculating means (10) for calculating the vertical interpolation with respect to the interpolation result of said first difference value interpolation calculating means; and

a digital filter circuit (253-265) for filtering the output signal of said second difference value interpolation calculating means.

9. A digital zooming system as claimed in claim 8, wherein said digital filter circuit (253-265) satisfies the following characteristic equation:

$$H(z) = \frac{0.75 + 0.5z^{-1} + 0.75z^{-2}}{2}$$

10. A digital zooming system as claimed in claim 8 or 9, wherein assuming that the distance between said two neighbouring pixels consisting of a first pixel and a second pixel equals one and that the value of an arbitrary pixel is known, said first difference value interpolation calculating means (9) performs said horizontal interpolation by adding a first value obtained by multiplying the value of said first pixel by the distance between said arbitrary pixel and said second pixel, to a second value obtained by multiplying the value of said second pixel by the distance between said arbitrary pixel and said first pixel.

11. A digital zooming system as claimed in claim 8, 9 or 10, wherein said first difference value interpolation calculating means (9) comprises a delay circuit (230) for delaying said calculated value for one horizontal scanning period.

12. A digital zooming system as claimed in claim 11, wherein said second difference value interpolation calculating means (10) comprises selecting means (252) for selectively outputting the signal of said first difference value interpolation calculating means or the signal delayed for one horizontal scanning period.

13. A digital zooming system as claimed in any preceding claim, wherein said address generating means (13) comprises write-address generating means (350-352) for generating the write-address of said recording means, and read-address generating means (353-360) for generating the read-address of said recording means, whereby the write-address or the read-address is selectively produced.

14. A digital zooming system as claimed in any preceding claim, wherein said coefficient generating means (14) comprises:

counting means (400,450) for counting a predetermined number of sections constituting the distance between said two neighbouring pixels, the distance being set to one;

sum-value coefficient generating means (404) comprising first horizontal-direction coefficient generating means (401-403) for receiving the output signal of said counting means having said predetermined number of intervals and the zooming factor so as to obtain the distance between an arbitrary point and the first pixel, and second horizontal-direction coefficient generating means for subtracting the first horizontal-direction coefficient from one so as to calculate the distance between the arbitrary point and the second pixel; and

difference-value coefficient generating means (454) comprising first vertical-direction coefficient generating means (451-453) for receiving the output signal of said counting means having said predetermined number of intervals and the zooming factor so as to obtain the distance between the arbitrary point and the first pixel, and second vertical-direction coefficient generating means for subtracting the first vertical-direction coefficient from one so as to calculate the distance between the arbitrary point and the second pixel.

15. A digital zooming system as claimed in any preceding claim, wherein said sum/difference signal mixing means (11) comprises:

a first adder (300) for receiving said sum-value interpolation signal and adding said predetermined number thereto;

a second adder (301) for adding said difference-value interpolation signal to said sum-value interpolation signal;

a third adder (305) for subtracting the difference-value interpolation signal divided by two, from the result of said first adder divided by two;

a fourth adder (306) for subtracting the predetermined number divided by two, from the result of said second adder divided by two; and

selection means (311) for selectively outputting the output signals of said third adder and said fourth adder.

16. A digital zooming method comprising the steps of:

storing digital video signals (such as S1 and S2) having a colour array each colour element of which is arranged in a predetermined order;

calculating sum value (Y) and difference value (D) for the digital video signals, said sum and difference values (Y and D) having a relationship expressed:

$$Y = S1 + S2$$
$$D = S2 - S1.$$

producing the sum-value's horizontal- and vertical-interpolation values at an arbitrary point between first and second pixels by, in the assumption that the distance between said pixels equals one, adding a first value obtained by multiplying the value of said first pixel by the distance between said arbitrary point and said second pixel, to a second value obtained by multiplying the value of said second pixel by the distance between said arbitrary point and said first pixel;

producing the difference-value's horizontal-interpolation value at an arbitrary point between said first and second pixels by, in the assumption that the distance between said pixels equals one, adding a third value obtained by multiplying the value of said first pixel by the distance between said arbitrary point and said second pixel, to a fourth value obtained by multiplying the value of said second pixel by the distance between said arbitrary point and said first pixel;

selectively generating said difference-value horizontal interpolation signal and a delayed signal, and filtering the selected signal according to the equation:

$$H(z) = \frac{0.75 + 0.5z^{-1} + 0.75z^{-2}}{2}$$

and then producing said difference-value vertical interpolation signal; and

receiving the sum-value and difference-value interpolation signals and mixing said interpolation signals to form said colour array, each colour element of which is arranged in said predetermined order and thereby produce a magnified image.

# FIG. 1

# FIG. 2

EP 0 589 721 A1

**FIG. 3**

# FIG. 4

EP 0 589 721 A1

# FIG. 5

EP 0 589 721 A1

FIG. 6

EP 0 589 721 A1

# FIG. 7

# FIG. 8

EP 0 589 721 A1

# FIG. 9A

| CK, DHD → | 32 COUNTER (400) | → | β VALUE GENERATOR (401) | → | D Q (402) CK | → | D Q (403) CK | → | Hβ, 1−β (404) → Hα |

COMPARING MEANS (405) → RCOLCK, FS1CK, FS2CK

D Q (406) CK → D Q (407) CK → COMPARING MEANS (408) → DRCOLCK

ZRD

# FIG. 9B

HD → 32 COUNTER (450) → β VALUE GENERATOR (451) → D Q (452) HD → D Q (453) HD → Vβ, 1−β (454) → Vα

DVD

ZRD

COMPARING MEANS (455) → PROWCK, YDLDC, VDLCS

EP 0 589 721 A1

# FIG. 10

CK

23o S11 S21 S12 S22 S13 S23 S14 S24

FS1CK

FS2CK

24o S11 S12 S13 S14

25o S21 S22 S23 S24

Y S11 S11+S21 S12+S21 S12+S22

D $-S_1$ S21-S11 S21-S12 S22-S12 S22-S13

# FIG. 11

RROWCK

ROW ADD. 1 2 3 4 5 6 7

YDLDC

DVLCS

D' 1st LINE 2nd LINE 3rd LINE 4th LINE 5th LINE 6th LINE 7th LINE

DD' 1st LINE 2nd LINE 3rd LINE 4th LINE 5th LINE 6th LINE

D" 1st 2nd 3rd 4th 3rd 4th 5th 6eh

**European Patent Office**    **EUROPEAN SEARCH REPORT**    Application Number

EP 93 30 7596

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| A | EP-A-0 483 837 (SANYO ELECTRIC)<br>* column 4, line 36 – column 5, line 6 *<br>* column 12, line 38 – column 13, line 25 *<br>* column 18, line 20 – column 20, line 15 * | 1-15 | H04N5/262<br>H04N9/74 |
| A | US-A-5 136 370 (YOUNG-BAE CHI)<br>* column 1, line 66 – column 3, line 53 * | 1,15 | |
| A | SIGNAL PROCESSING IV: THEORIES AND APPLICATIONS<br>vol. III , 1988 , AMSTERDAM, NETHERLANDS<br>pages 1445 – 1448 XP000093910<br>YAO WANG, SANJIT K. MITRA 'edge preserved image zooming'<br>* page 1445, left column, line 5 – right column, line 18 * | 1,15 | |
| P,A | DE-A-42 10 116 (SAMSUNG ELECTRONICS)<br>* page 2, line 39 – page 5, line 47 * | 1-16 | TECHNICAL FIELDS SEARCHED (Int.Cl.5)<br><br>H04N<br>G06F |

The present search report has been drawn up for all claims

| Place of search | Date of completion of the search | Examiner |
|---|---|---|
| THE HAGUE | 22 December 1993 | Wentzel, J |